# EUROPÄISCHE PATENTANMELDUNG

(11) **EP 0 992 616 A2**
(43) Veröffentlichungstag der Anmeldung: **12.04.2000**
(21) Anmeldenummer: 99115377.6
(22) Anmeldetag: 04.08.1999
(51) Int. Cl.: C25D 17/00, C25D 5/18, H05K 3/24

(54) **Einrichtung zur Behandlung von Gegenständen, insbesondere Galvanisiereinrichtung für Leiterplatten**

(30) Priorität: 05.08.1998 DE 19835332
(71) Anmelder: Gebr. Schmid GmbH & Co., D-72250 Freudenstadt (DE)
(72) Erfinder: Schmid, Dieter C., Dipl.-Ing., 72250 Freudenstadt-Dietersweiler (DE)
(74) Vertreter: Patentanwälte Ruff, Beier, Schöndorf und Mütschele

(57) **Zusammenfassung**

Durch die Erfindung wird eine Einrichtung zur Behandlung von Leiterplatte (14) o.dgl. geschaffen, die in einer Behandlungskammer (11) mittels Transportmitteln (15) auf einer Durchlaufbahn (13) durch ein Behandlungsmedium (12) transportiert werden, wobei Kontaktiermittel (50) zur elektrischen Kontaktierung und Stromzuführung von einer Stromversorgung (55) zu den Leiterplatten sowie eine Zusatz-Strombeaufschlagung (57) über wenigstens eine Zusatz-Kontaktierung vorgesehen sind. Durch eine erfindungsgemäße Ausbildung von Kontaktiermitteln bzw. Kontaktsektoren können kurze Zusatz-Stromstöße an die Leiterplatten gegeben werden. Die Erzeugung der kurzen Zusatz-Stromstöße kann über eine mechanische Kommutierung oder über Schaltmittel bzw. Schalterbauelemente erfolgen. Ein bevorzugtes Anwendungsbeispiel ist eine Galvanisiereinrichtung, in der durch Anlegen von kurzen, entgegengesetzt gepolten Zusatz-Stromstößen störende Randablagerungen an Durchbrüchen (22) der Leiterplatte (14) während der Beschichtung abgetragen werden können.

## Beschreibung

### ANWENDUNGSGEBIET UND STAND DER TECHNIK

Die Erfindung betrifft eine Einrichtung zur Behandlung von Gegenständen, insbesondere eine Galvanisiereinrichtung für Leiterplatten, auf einer Durchlaufbahn durch eine Behandlungskammer, mit Transportmitteln für den Transport der Gegenstände durch ein Behandlungsmedium, wie etwa eine Elektrolytlösung, und mit Kontaktiermitteln zur elektrischen Kontaktierung und Stromzuführung von einer Stromversorgung zu den Gegenständen.

Eine solche Einrichtung ist aus der EP 677 599 B1 bekannt. Darin werden Kontaktiermittel beschrieben, die mehrere elektrisch voneinander isolierte und elektrisch unterschiedlich kontaktierte Kontaktsektoren aufweisen, die in einem Behandlungsmedium umlaufen. In der Ausführung wird beschrieben, daß sie in Umlaufrichtung abwechselnd kathodisch und anodisch an die Stromversorgung angeschlossen werden können. Dadurch ist es möglich, im kathodisch kontaktierten Bereich eine Stromzuführung an die Gegenstände vorzunehmen. Dabei ergibt sich eine zumindest teilweise Metallisierung der Kontaktierungsflächen. Um diese Metallisierung mittels einer Entmetallisierungskathode zu entfernen, werden die Kontaktierungsflächen anschließend anodisch beaufschlagt.

Aus der DE 196 28 784 ist eine Einrichtung bekannt, bei der sich aufeinanderfolgende Kontaktsektoren ähnlich der EP 677 599 B1 in Umfangsrichtung einander zumindest teilweise überlappen. Damit soll die Kontaktierung weiter verbessert werden und Funkenbildung beim Übergang der Stromführung verringert werden.

### AUFGABE UND LÖSUNG

Der Erfindung liegt die Aufgabe zugrunde, eine Einrichtung gemäß dem Oberbegriff zu schaffen, die eine Kontaktierung verbessert, eine Behandlung der Gegenstände funktional erweitert sowie mit geringem Aufwand realisierbar ist und möglichst störungsfrei arbeitet.

Diese Aufgabe wird gelöst durch den Anspruch 1. Vorteilhafte Ausgestaltungen der Erfindung sind Gegenstand der Unteransprüche. Die Zusatz-Strombeaufschlagung der Gegenstände mittels wenigstens einer Zusatz-Kontaktierung. Die Zusatz-Strombeaufschlagung kann bei einer eigenen Zusatz-Kontaktierung in weiten Grenzen unabhängig von der üblichen Stromversorgung über die Kontaktiermittel gehandhabt werden. Beispielsweise kann die Zusatz-Strombeaufschlagung eine zu der üblichen Stromversorgung über die Kontaktiermittel entgegengesetzte Polarität aufweisen. Die Zusatz-Strombeaufschlagung erfolgt bevorzugt nur an die Gegenstände und benötigt vorteilhaft keine speziell ausgebildeten Entmetallisierungskathoden oder sonstige anodisch beaufschlagte Elemente, die dann kathodisch beaufschlagt werden müßten.

Das Spannungspotential der Zusatz-Stromquelle bzw. der Zusatz-Beaufschlagung liegt vorteilhaft über dem des Behandlungsmediums. So kann bei einer Galvanisiereinrichtung für Leiterplatten, in der normalerweise Kupfer aus dem Behandlungsmedium kathodisch auf die Leiterplatten angelagert wird, ein Teil der Schicht wieder kontrollierbar abgetragen werden. Dies ist beispielsweise dann vorteilhaft, wenn die Gegenstände bzw. Leiterplatten Ausnehmungen oder Löcher aufweisen. In solchen Fällen kann beobachtet werden, daß sich an den Ausnehmungsrändern zum Teil besonders starke Anlagerungen bzw. Überstände bilden, durch die die Ausnehmung bzw. das Loch "zuwachsen" kann, bevor die Innenwandungen eine vollständige Beschichtung aufweisen. Durch ein teilweises Abtragen der Schicht bzw. insbesondere solcher Randablagerungen wird die Beschichtungsqualität insbesondere im Bereich von derartigen Ausnehmungen stark verbessert. Ein Abtragen von Grenzschichten an der Beschichtung kann diese insgesamt beschleunigen.

Als besonders vorteilhaft zum teilweisen Abtragen wird eine impulsartige Zusatz-Strombeaufschlagung angesehen mit Impulsdauern der Zusatz-Stromstöße, die etwa im Verhältnis 1:10 bis 1:30 zu der Dauer der üblichen Stromversorgung erfolgen. Die Impulsdauern können z.B. im Bereich von zwei Millisekunden bis einhundert Millisekunden liegen, beispielsweise etwa dreißig Millisekunden. Durch die impulsartige Umpolung der Gegenstände mit einem Spannungspotential, das über dem des Behandlungsmediums liegt, wobei der Potentialunterschied vorzugsweise ähnlich groß ist wie beim normalen Beschichtungsvorgang oder größer, können spitze bzw. vorstehende Ablagerungen besonders gut entfernt werden. Nicht nur Ränder von Ausnehmungen sondern Unebenheiten allgemein, beispielsweise infolge eines ungleichmäßigen Schichtaufbaus, sowie störende Grenzschichten können auf diese Weise geglättet bzw. beseitigt werden.

Die Zusatz-Stromquelle kann eine Impulsstromquelle für kurze Zusatz-Stromstöße sein. Die Stromstärke der Zusatz-Stromstöße kann über der der üblichen Stromversorgung liegen, beispielsweise etwa zwei- bis zehnmal so hoch.

Gemäß einer Ausbildung der Erfindung können die Kontaktiermittel umlaufende Walzen oder Scheiben umfassen, die an den Gegenständen mit ihrem Außenumfang anliegen. Bevorzugt bilden sie zumindest teilweise Transportmittel für die Gegenstände, besonders bevorzugt im wesentlichen die einzigen Transportmittel. Dazu können sie beidseitig der Oberfläche der Gegenstände einander gegenüberliegend oder versetzt zueinander angeordnet sein, und sich gegenläufig drehen. Eine Zusatz-Kontaktierung der Gegenstände kann vorteilhaft über die Kontaktiermittel erfolgen. Dazu ist zusätzlich zu deren Kontaktierung beispielsweise wenigstens eine Zusatz-Kontaktfläche vorgesehen, die zumindest teilweise die normale Kontaktierung ersetzen kann. Dies bedeutet, daß an bereits vorhandenen Kontaktiermitteln neue Zusatz-Kontaktflächen geschaffen werden, die beispielsweise durch "Dazwischenschieben" oder Ersetzen mittels Umkontaktieren von vorhandenen Kontaktflächen geschaffen werden können.

Bevorzugt sind Zusatz-Kontaktfläche und Kontaktiermittel derart ausgebildet und betätigt, daß in bestimmten Stellungen der Kontaktiermittel, also zu bestimmten Zeitpunkten, die Zusatz-Kontaktfläche der einzige Berührpunkt eines Kontaktiermittels mit den Gegenständen ist. Besonders bevorzugt erfolgt zu diesen Zeitpunkten keine übliche Stromzuführung zu den Gegenständen. Dies kann erreicht werden, indem die Stromversorgung abgetrennt wird oder keine Kontaktierung an die Gegenstände stattfindet.

Gemäß einer alternativen Ausführung der Erfindung kann die Zusatz-Kontaktierung über Zusatz-Kontaktiermittel erfolgen, die zumindest teilweise an den Gegenständen anliegen und Zusatz-Kontaktflächen aufweisen können. Vor allem bei einer drehbaren Ausführung der Zusatz-Kontaktiermittel, insbesondere nach Art von Rädern, Scheiben o. dgl., ist es von Vorteil, wenn die Zusatz-Kontaktflächen eine begrenzte Ausdehnung aufweisen. Sie können auf einen bestimmten Bogenwinkel begrenzt sein, der bevorzugt maximal 10° betragen sollte, insbesondere bei ca. 4° liegen könnte. Bei einer Ausführung der Einrichtung mit Zusatz-Kontaktiermitteln zusätzlich zu den üblichen Kontaktiermitteln ist es möglich, diese nach Art von Zahnrädern auszubilden, so daß die zusätzlichen Kontaktiermittel nur in bestimmten Bereichen bzw. zu bestimmten Zeitpunkten an den Gegenständen anliegen können.

Zur Erzeugung von kurzen Zusatz-Stromstößen an den Gegenständen ist eine mechanische Kommutierung der Zusatz-Kontaktflächen mit den Gegenständen und/oder der Zusatz-Stromquelle möglich. Auf diese Weise können aufwendige und fehleranfällige Leistungselektronik oder andere Schaltmittel eingespart werden. Die Ausdehnung der Zusatz-Kontaktflächen kann allgemein in Abhängigkeit von der Umdrehungsgeschwindigkeit, der Anzahl der Zusatz-Kontaktflächen sowie der gewünschten Impulsdauer bestimmt werden.

Alternativ ist eine Erzeugung von Zusatz-Stromstößen mittels Schaltern, beispielsweise Leistungsschaltern, möglich. Auf diese Weise kann die mechanische Anordnung einfacher gehalten werden und beispielsweise Funkenbildung bei einer Kommutierung des Stromflusses o. dgl. vermieden werden.

Die Kontaktiermittel können wenigstens zwei elektrisch gegeneinander isolierte, im Behandlungsmedium umlaufende, vorzugsweise elektrisch unterschiedlich kontaktierte Kontaktsektoren aufweisen, zwischen denen zumindest teilweise Zusatz-Kontaktflächen angeordnet sind. Die Kontaktsektoren können einander in Umfangsrichtung zumindest teilweise überlappend ausgebildet sein, beispielsweise schräg oder stufenförmig verlaufen mit elektrisch isolierenden Trennungen. Im Fall von radähnlichen Kommutierungsmitteln verlaufen die Zusatz-Kontaktflächen bevorzugt ohne Unterbrechung in axialer Richtung.

Jedes Kontaktiermittel weist vorzugsweise Stromeinleitmittel auf, die mit einem Teil der Kontaktsektoren oder Zusatz-Kontaktflächen verbunden und außerhalb der Behandlungsflüssigkeit angeordnet sind. Sie können entweder an die Stromversorgung oder an die Zusatz-Stromquelle angeschlossen sein. Vorteilhaft sind die Stromeinleitmittel zur mechanischen Kommutierung des Stromflusses an diejenigen Kontaktsektoren oder Zusatz-Kontaktflächen, die sich gerade mit den Gegenständen in Kontakt befinden, ausgebildet. Verwendung finden hier vorteilhaft Schleifer, Bürsten oder Kohlen, ähnlich wie bei Elektromotoren. Bevorzugt sind die Stromeinleitmittel für die Zusatz-Kontaktflächen versetzt zu denjenigen der Kontaktsektoren, insbesondere axial versetzt.

Unter einem Aspekt der Erfindung wird eine Einrichtung gemäß dem Oberbegriff geschaffen, bei der die Kontaktiermittel mehrere elektrisch voneinander isolierte und im Behandlungsmedium umlaufende Kontaktsektoren aufweisen, die elektrisch unterschiedlich kontaktiert sind und einander in Umfangsrichtung zumindest teilweise überlappend ausgebildet sind.

Alternativ kann durch die Erfindung eine Einrichtung gemäß dem Oberbegriff geschaffen werden, bei der die Kontaktiermittel mehrere elektrisch voneinander isolierte im Behandlungsmedium umlaufende Kontaktsektoren aufweisen, die elektrisch leiten und in Umlaufrichtung abwechselnd kathodisch und anodisch an die Stromversorgung anschließbar sind, wobei die Einrichtung eine Zusatz-Strombeaufschlagung mit wenigstens einer Zusatz-Kontaktierung aufweist, die durch eine Zusatz-Strombeaufschlagung mit wenigstens einer Zusatz-Kontaktierung gekennzeichnet ist.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### KURZBESCHREIBUNG DER ZEICHNUNGEN

Ausführungsbeispiele der Erfindung sind in den Zeichnungen dargestellt und werden im folgenden näher erläutert. In den Zeichnungen zeigen:
- Fig. 1: ein schematischer Teilquerschnitt durch eine Galvanisiereinrichtung,
- Fig. 2: ein vergrößerter Ausschnitt einer Einrichtung ähnlich Fig. 1 mit einer Variante der Kontaktiermittel und der Zusatz-Kontaktiermittel,
- Fig. 3: eine Seitenansicht einer Ausführungsvariante von Zusatz-Kontaktiermitteln,
- Fig. 4: eine Draufsicht einer besonders einfachen Kombination von Kontaktiermitteln mit Zusatz-Kontaktflächen und
- Fig. 5: ein Funktionsschema zur Zuordnung eines Potentials zu einer Winkelstellung.

### DETAILLIERTE BESCHREIBUNG DER AUSFÜHRUNGSBEISPIELE

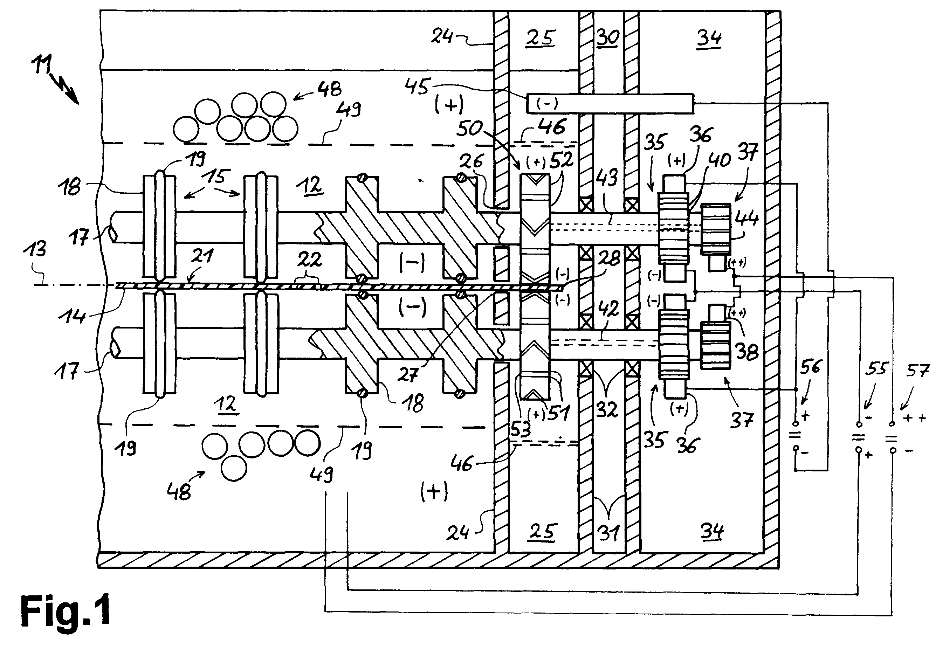

Fig. 1 zeigt schematisch einen Teil einer Galvanisiereinrichtung zum Metallauftrag mit einer Behandlungskammer 11, die mit einer Elektrolytlösung 12 als Behandlungsmedium gefüllt ist. In der bevorzugt langgestreckten Behandlungskammer 11 befindet sich eine senkrecht in die Zeichenebene hinein verlaufende Durchlaufbahn 13. In dieser werden galvanisch zu behandelnde Gegenstände gefördert, als Beispiel ist eine Leiterplatte 14 dargestellt. Die Leiterplatte 14 wird horizontal liegend von Transportmitteln in Form von Transporträdern 15 durch die Behandlungskammer 11 gefördert. Die Transporträder können, wie in Fig. 1 dargestellt, von einer Welle 17 vorstehende Scheiben 18 sein, die sich jeweils paarweise gegenüberstehen und mit einem elastischen, umlaufenden Vorsprung an den Leiterplatten 14 anliegen. Die Vorsprünge sind in Fig. 1 als in eine Nut der Scheiben 18 eingelegte O-Ringe 19, beispielsweise aus Gummi, ausgebildet.

In der Behandlungskammer 11 werden die zuvor leitfähig gemachten Leiterplatten 14 beidseitig mit einer elektrisch leitenden Schicht überzogen, bevorzugt einer dünnen Metall- bzw. Kupferschicht 21. Die Leiterplatte 14 ist mit Durchbrüchen 22 in Form von feinen Löchern versehen; weiters möglich sind beispielsweise Ausnehmungen nach Art von Sacklöchern o. dgl. Unter anderem ist es Ziel der vorliegenden Erfindung, die Beschichtung an den Innenwänden der Durchbrüche zu verbessern. Eine elektrisch leitende Schicht auf Leiterplatten 14 und in Durchbrüchen 22 kann alternativ zu einem Metall aus einem elektrisch leitenden Polymer, beispielsweise einem entsprechenden Kunststoff, oder aus Graphit o. dgl. bestehen.

Die Wellen 17 der in kurzen Abständen jeweils gegenüberliegend und gegenläufig angetriebenen Transporträder 15 ragen durch eine Trennwand 24 in eine Kontaktierkammer 25. In der Trennwand 24 sind Durchgangsöffnungen 26 für die Wellen 17 sowie ein Schlitz 27 für die Leiterplatte 14, die in die Kontaktierkammer 25 reicht. Zusätzlich können weitere Öffnungen für einen Elektrolytaustausch zwischen Behandlungskammer 11 und Kontaktierkammer 25 vorhanden sein. Die Leiterplatte 14 weist in dem in der Kontaktierkammer 25 verlaufenden Randbereich einen sogenannten Galvanorand 28 auf, der im wesentlichen zur elektrischen Kontaktierung während der Galvanisierung bzw. Beschichtung vorgesehen ist.

Die Kontaktierräder 50 als Kontaktiermittel bestehen aus je einer in der Kontaktierkammer 25 auf der Welle 17 angeordneten Scheibe, von denen sich jeweils zwei gegenüberliegen. Ihr Außendurchmesser entspricht dem der Transporträder 15, so daß sie den Galvanorand 28 mit der Breite des Außenumfangs berühren. Sie sind von der Behandlungskammer 11 und von dem in anodisch angeschlossenen Anodenkörben 49 befindlichen galvanisch aufzubringendem Metall getrennt, das in der Fig.1 in Form von Kupferkugeln 48 vorliegt.

Der Außenumfang der Kontaktierräder 50 ist durch V-förmige oder axial verlaufende Isoliersektoren 51 in Kontaktsektoren 52 unterteilt. In Fig. 1 wechseln sich V-förmige und axial verlaufende Isoliersektoren 51 ab, möglich sind jedoch auch andere Teilungsverhältnisse, beispielsweise jeweils zwei V-förmige und ein axial verlaufender Sektor. Die axial verlaufenden Isoliersektoren 51 trennen axial verlaufende Zusatz-Flächen 53 ab. Es ist deutlich zu erkennen, daß die Zusatz-Kontaktflächen 53 einen wesentlich geringeren Umfangsbereich einnehmen als die Kontaktsektoren 52. Ebenso sind die die Zusatz-Kontaktflächen 53 abtrennenden Isoliersektoren 51 sehr schmal ausgeführt und nur strichförmig dargestellt. Dies bewirkt, daß zwischen einem Kontakt der Kontaktsektoren und einem anschließenden Kontakt durch die Zusatz-Kontaktflächen 53 an die Leiterplatte 14 der Übergang durch Drehen der Räder 50 sehr rasch und mit sehr geringer Totzeit erfolgt.

Angrenzend an die Kontaktierkammer 25 ist ein Abdichtabschnitt 30 mit zwei Zwischenwänden 31 vorgesehen. Die Wellen 17 verlaufen in abdichtenden Lagerungen 32, während die Leiterplatte 14 in der Kontaktierkammer 25 endet. Durch die doppelte Ausführung des Abdichtabschnitts 30 mit den Zwischenwänden 31 soll eine besonders gute Abdichtung gewährleistet sein, je nach Anforderung bzw. Ausführung kann eine Zwischenwand ausreichen. Der Bereich zwischen den Wänden 31 kann zum Antrieb der Wellen 17 genutzt werden, beispielsweise durch von einer gemeinsamen Achse angetriebene Kegelräder, Zahnriemen o. dgl.

An den Abdichtabschnitt 30 schließt sich ein Anschlußbereich 34 an. In ihm befinden sich Stromeinleitmittel 35 auf jeder Welle 17, die von Stromzuleitungen 36 kontaktiert werden, welche nach Art von Kollektorbürsten ausgeführt sein können. Die Stromzuleitungen 36 sind dabei einerseits an dem zur Durchlaufbahn 13 hin weisenden Bereich des Außenumfangs der Stromeinleitmittel 35 und andererseits diesem Bereich ungefähr gegenüberliegend daran angeordnet.

An den Enden der Wellen 17 sind Zusatz-Stromeinleitmittel 37 angeordnet, die nur zu der Durchlaufbahn 13 hin weisende Zusatz-Stromzuleitungen 38 aufweisen. Diese können ebenfalls nach Art von Kollektorbürsten ausgebildet sein.

Einzelne Kommutatorsektoren 40 der Stromeinleitmittel 35 sind mit den Kontaktsektoren 52 der Kontaktierräder 50 über langgestrichelt dargestellte Kontaktierleitungen 42 verbunden. Diese können z.B. als innerhalb der Wellen 17 verdeckt verlaufende Leiterschienen ausgebildet sein oder alternativ durch Kunststoffhülsen o. dgl. nach außen verdeckt sein.

Die Zusatz-Stromeinleitmittel 37 sind über kurzgestrichelte Zusatz-Kontaktierleitungen 43 mit den Zusatz-Kontaktflächen 53 verbunden. Dies kann in der Art erfolgen, daß jedem Zusatz-Kommutatorsektor 44 eine Zusatz-Kontaktfläche 53 in derselben Winkelstellung zugeordnet ist, oder eine Zuleitung 43 alle Kommutatorsektoren der Zusatz-Stromeinleitmittel mit allen Zusatz-Kontaktsektoren verbindet.

Weitere Ausführungsmöglichkeiten der Kontaktierräder 50 bzw. der Kontaktiermittel und Zusatz-Kontaktiermittel sind in den nachfolgenden Figuren dargestellt.

In der Kontaktierkammer 25 ist im oberen Teil beispielhaft eine Entmetallisierungskathode 45 so angeordnet, daß sie einem von der Leiterplatte 14 abgewandten Bereich der kontaktierenden Räder 50 gegenüberliegt. Eine solche Entmetallisierungskathode 45 kann vorgesehen sein, alternativ kann ihre Funktion von der Leiterplatte selber übernommen werden. In der Fig. 1 ist zwischen der Entmetallisierungskathode 45 und den Kontaktierrädern 50 eine zumindest teilweise durchlässige Trennwand 46 vorgesehen. Sie kann eine semipermeable Membran sein, beispielsweise aus Polypropylen. Die Trennwände 46 lassen zwar Stromfluß und Ionenwanderung von den Kontaktierrädern 50 weg, insbesondere hin zu der Entmetallisierungskathode 45, zu, nicht jedoch in umgekehrter Richtung.

Die zur Durchlaufbahn 13 hin an den Stromeinleitmitteln 35 angeordneten Stromzuleitungen 36 bzw. entsprechende Bürsten sind mit dem Minuspol einer Galvanisierungsstromquelle 55 verbunden, deren Pluspol mit der Elektrolytlösung 12 und/oder den Anodenkörben 49 verbunden ist. Die von der Durchlaufbahn 13 abgewandt an den Stromeinleitmitteln 35 anliegenden Stromzuleitungen 36 sind an den Pluspol einer Gleichspannungsstromquelle 56 angeschlossen, deren Minuspol mit einer Entmetallisierungskathode 45 verbunden sein kann.

Die Zusatz-Stromzuleitungen 38 der Zusatz-Stromeinleitmittel 37 sind mit dem Pluspol einer Zusatz-Stromquelle 57 zur Zusatz-Strombeaufschlagung der Leiterplatten 14 verbunden. Durch die Kennzeichnung des Pluspols der Zusatz-Stromquelle mit einem Doppelplus soll verdeutlicht werden, daß deren Potential über dem der Galvanisierungsstromquelle 55 liegt. Der Minuspol kann, wie dargestellt, zur Entkupferung der Elektrolytlösung 12 in die Behandlungskammer 11 geführt sein.

### FUNKTION

Die übliche Beschichtung der Leiterplatten 14 sowie der Durchbrüche 22 mit von den Kupferkugeln 48 abgelöstem Kupfer erfolgt durch Beaufschlagung der leitend gemachten Leiterplattenoberfläche mit negativem Potential über die Kontaktierräder 50 sowie die innere Stromzuleitung 36 über die Galvanisierungsstromquelle 55. Während die die Leiterplatte 14 kontaktierenden Kontaktsektoren 52 mit dem Minuspol der Galvanisierungsstromquelle 55 zur Anlagerung von Kupfer verbunden sind, sind die abgewandten Kontaktsektoren über die außen angebrachten Stromzuleitungen 36 mit dem Pluspol der Entmetallisierungsstromquelle 56 verbunden. Dies bewirkt, daß von den an positives Potential gelegten Kontaktsektoren 52 das während der Beaufschlagung mit negativem Potential angelagerte Kupfer z.B. auf die Entmetallisierunqskathode 45 oder die Leiterplatte 14 abgeschieden wird. Auf diese Weise werden dauerhafte Kupferanlagerungen an den Kontaktierrädern 50 bzw. den Kontaktsektoren 52 vermieden und somit die Gefahr, daß dadurch die Isoliersektoren 51 zuwachsen bzw. überbrückt werden. Der in Fig. 1 dargestellte V-förmige Verlauf der Isoliersektoren 51 bewirkt einen fließenden Übergang des Kontakts der Leiterplatte 14 von einem Kontaktsektor 52 zum nächsten ohne störende Funkenbildung oder Kontaktstörungen.

Zu den Zeitpunkten, zu denen die Zusatz-Kontaktflächen 53 an den Leiterplatten 14 anliegen, ist die Leiterplatte bzw. deren Galvanorand 28 über die Zusatz-Stromeinleitmittel 37 mit dem Pluspol der Zusatz-Stromquelle verbunden. Dabei sind die Kontaktierräder 50 bevorzugt so ausgeführt, daß zu jeweils exakt gleichen Zeiten alle Zusatz-Kontaktflächen 53 mit dem Galvanorand 28 verbunden sind. Zu diesem Zeitpunkt wird die Polung der Leiterplattenoberfläche umgekehrt (von - auf ++), so daß ihr Potential nun über dem der Elektrolytlösung 12 liegt. Demzufolge erfolgt ein Abtrag von Kupfer bzw der obersten Schicht von der Leiterplatte 14 weg. Ist nun der dabei eingeleitete Strom höher, vorzugsweise erheblich höher, als der beim üblichen Galvanisierungsvorgang fließende, erfolgt ein Kupferabtrag vor allem an exponierten Stellen der Leiterplatte 14. Dies sind vor allem die Ränder um die Durchbrüche 22, an denen störend überstehende Kupferränder beseitigt werden sollen. Um jedoch insgesamt ein Anwachsen der Kupferschicht zu bewirken, muß die Kupferanlagerung im Endeffekt den Kupferabtrag übertreffen. Dies wird vorteilhaft erreicht, indem die Leiterplatten 14 erheblich länger mit negativen Potential als mit hohem positiven Potential verbunden sind. Realisiert werden kann das gemäß Fig. 1 durch eine mechanische Kommutierung der Zusatz-Stromquelle 57 an die Leiterplatte 14. Die geringe Breite der Zusatz-Kontaktflächen 53 bewirkt, daß diese nur kurzzeitig kontaktieren und so den Kupferabtrag zeitlich stark beschränken. Eine mechanische Kommutierung kann ebenfalls an den Zusatz-Stromeinleitmitteln 37 durch geeignete Dimensionierung der Zusatz-Kommutatorsektoren 44 bewirkt werden.

Alternativ ist es möglich, über Schalter, evtl. elektronische Leistungsschalter, die Zusatz-Stromquelle 57 in einem Moment, in dem eine Zusatz-Kontaktfläche 53 in Kontakt mit der Leiterplatte 14 ist, zur Erzeugung eines kurzen Impulses als Zusatz-Stromstoß an- und abzuschalten. Mit Hilfe von solchen Leistungsschaltern lassen sich sehr kurze bis kürzeste Impulsdauern im Millisekundenbereich erzielen.

Eine Unterteilung der Zusatz-Stromeinleitmittel 37 in schmale Zusatz-Kommutatorsektoren 44 hat den Vorteil, daß bei einer breiteren Ausführung der Zusatz-Kontaktflächen 53 diese bereits sicher die Leiterplatte 14 kontaktieren, wenn an den Einleitmitteln die Verbindung zur Zusatz-Stromquelle 57 hergestellt wird. Eine eventuelle Funkenbildung wird so in den Anschlußbereich 34 verlegt und in der Kontaktierkammer 25 vermieden.

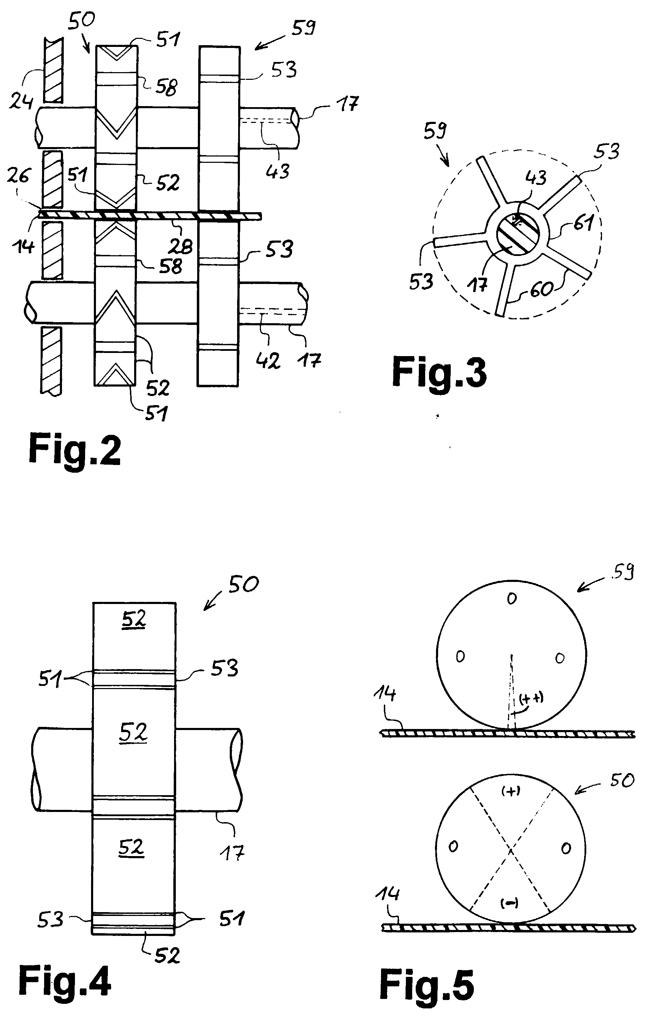

Eine alternative Ausführung der Kontaktierung ist in Fig. 2 dargestellt. Hier sind die Kontaktierräder 50 zwar auf den ersten Blick ähnlich wie in Fig. 1 durch V-förmige Isoliersektoren 51 unterteilt, hinzu kommen jedoch weitere axial verlaufende Isoliersektoren 58. Die dazwischen liegenden Kontaktsektoren 52 sind über die Kontaktierleitungen 42 mit nicht dargestellten Stromeinleitmitteln verbunden. Neben den Kontaktierrädern 50 sind auf den Wellen 17 Zusatz-Kontaktierräder 59 angebracht, die schmale Zusatz-Kontaktflächen 53 aufweisen. Diese Zusatz-Kontaktflächen 53 sind schmaler als die axial verlaufenden Isoliersektoren 58 auf den Kontaktierrädern 50. Zwischen den Zusatz-Kontaktflächen 53 ist die Umfangsfläche der Räder 59 bevorzugt isolierend.

Die Sektoren sind so angeordnet, daß das Zeitintervall, in dem ein axial verlaufender Isoliersektor 58 der Kontaktierräder 50 am Galvanorand 28 anliegt, früher anfängt und später aufhört als ein solches, in dem die Zusatz-Kontaktflächen 53 den Galvanorand kontaktieren. Würde man in der in Fig. 2 dargestellten Winkelstellung die Räder 50 und 59 durch axiales Verschieben in Überdeckung bringen, so lägen die Zusatz-Kontaktflächen 53 genau innerhalb der axial verlaufenden Isoliersektoren 58. Eine Anordnung gemäß Fig. 2 eignet sich für eine mechanische Kommutierung bzw. Aufschaltung der Zusatz-Stromquelle mit kurzen Zusatz-Stromstößen als weitere Strombeaufschlagung. Ebenso möglich ist die Verwendung von Schaltmitteln.

Die Fig. 3 zeigt eine Seitenansicht einer möglichen Ausführungsform eines Zusatz-Kontaktierrades 59. Da, wie in Fig. 2 deutlich wird, jeweils nur eine schmale Zusatz-Kontaktfläche 53 an der Leiterplatte 14 anliegen muß, ist das Kontaktierrad 59 nach Art eines Zahnrades mit fünf Speichen 60 auf einer Nabe 61 versehen. Die Nabe 61 ist drehfest mit der Welle 17 verbunden. Innerhalb der Welle 17 verläuft die Zusatz-Kontaktierleitung 43, die mit den Speichen 60 leitend verbunden ist. Das Zahnrad ist bevorzugt aus Metall. Anstelle von metallischen Kontaktflächen können beispielsweise leitende Werkstoffe auf Basis von Graphit o. dgl. verwendet werden. Alternativ sind für die Speichen 60 Kunststoffausführungen mit metallischen Zusatz-Kontaktflächen 53 an ihrem Ende sowie leitenden Verbindungen derselben zu der Zusatz-Kontaktierleitung 43 möglich.

Die Zusatz-Kontaktierräder 59 können aber anstelle einer Anordnung gemäß Fig. 2 nicht nur neben den Kontaktierrädern 50 für die Galvanisierung verlaufen, sondern ebenso, bevorzugt abwechselnd, zwischen diesen. Auf diese Weise läßt sich die Breite des zur Kontaktierung benötigten Galvanorandes 28 der Leiterplatte 14 möglichst gering halten.

Fig. 4 zeigt ein Kontaktierrad 50 auf einer Welle 17, das breite Kontaktsektoren 52 sowie schmale Zusatz-Kontaktflächen 53 aufweist. Getrennt sind sie durch sehr schmale axial verlaufende Isoliersektoren 51. Ähnlich wie vorgehend beschrieben sind sowohl Kontaktsektoren 52 als auch Zusatz-Kontaktflächen 53 mittels in der Welle 17 verlaufender Kontaktierleitungen an entsprechende Stromeinleitmittel bzw. Stromquellen angeschlossen. Der Vorteil einer Ausbildung des Kontaktierrades gemäß Fig. 4 liegt darin, daß eine aufwendige Segmentierung des Außenumfangs der Kontaktiermittel vermieden werden kann. Die Leiterplatte 14 wird jeweils abwechselnd während einer Galvanisierungsphase von einem Kontaktsektor 52 an negatives Potential gelegt und, durch die Isolierung 51 hiervon getrennt, während einer kurzen Abtragphase über die zusätzliche Kontaktfläche 53 an ein hohes positives Potential. Die Isoliersektoren 51 verhindern, daß die Leiterplatte 14 gleichzeitig mit der Galvanisierungsstromquelle 55 und der Zusatz-Stromquelle 57 verbunden ist.

Bei einer Ausführung gemäß Fig. 4 zur mechanischen Kommutierung bestimmt das Verhältnis der Ausdehnung der Kontaktsektoren 52 zu den Zusatz-Kontaktflächen 53 die jeweiligen Berührdauern und somit Stromleitungsdauern. Zur mechanischen Erzeugung kurzer Zusatz-Stromstöße sind die Zusatz-Kontaktflächen 53 sehr schmal. Werden Schaltmittel o. dgl. zur Impulserzeugung verwendet, können sie etwas breiter sein.

Das Funktionsschema, in welchem Bereich der Außenumfang welches Potential aufweist, geht auch aus Fig. 5 hervor. Dort ist zur besseren Verständlichkeit eine getrennte Darstellung von Zusatz-Kontaktierrad 59 (oben) und Kontaktierrad 50 (unten) gewählt. In der Fig. 5 wird die Polung der Kontaktierung und der Zusatz-Kontaktierung abhängig von dem Winkelbereich dargestellt, in dem sich die Kontaktsektoren 52 bzw. Zusatz-Kontaktflächen 53 jeweils befinden, wobei diese nicht explizit eingezeichnet sind. Im oberen Teil wird deutlich, daß die Umfangsfläche des Zusatz-Kontaktierrades 59 oder einer entsprechenden Zusatz-Kontaktfläche 53 (bei einem gemeinsamen Kontaktierrad gemäß Fig. 1) nur in einem sehr schmalen, zu der Leiterplatte 14 hin weisenden Winkelbereich zur Erzeugung der Zusatz-Stromstöße an das Potential ++ gelegt ist. Alle anderen Winkelbereiche sind, durch eine 0 gekennzeichnet, neutral. Das im unteren Teil dargestellte Kontaktierrad 50 bzw. ein entsprechender Kontaktsektor ist in einem zu der Leiterplatte 14 hin weisenden Winkelbereich zur normalen Beschichtung an das Potential - gelegt. Zur Entmetallisierung ist ein gegenüberliegender etwa gleich großer Bereich an das Potential + gelegt und dazwischen neutral.

Sind die Kontaktflächen an einem Rad (Fig. 1) zusammengefaßt, so gilt der obere Teil der Fig. 5 für das jeweilige Potential der Zusatz-Kontaktierung und der untere Teil für das der üblichen Kontaktierung. Die gewählten Winkelbereiche sind nur exemplarisch, sie können unter Beibehaltung des Funktionsprinzips jeweils größer oder kleiner sein.

## Patentansprüche

1. Einrichtung zur Behandlung von Gegenständen, insbesondere Galvanisiereinrichtung für Leiterplatten (14), auf einer Durchlaufbahn (13) durch eine Behandlungskammer (11), mit Transportmitteln (15) für den Transport der Gegenstände durch ein Behandlungsmedium, wie eine Elektrolytlösung (12), und mit Kontaktiermitteln (50) zur elektrischen Kontaktierung (52) und Stromzuführung von einer Stromversorgung (55) zu den Gegenständen, gekennzeichnet durch eine Zusatz-Strombeaufschlagung mit wenigstens einer Zusatz-Kontaktierung (53).

2. Einrichtung nach Anspruch 1, dadurch gekennzeichnet, daß die Zusatz-Strombeaufschlagung eine zu der Stromversorgung (55) über die Kontaktiermittel (50) entgegengesetzte Polarität aufweist, wobei insbesondere das Spannungspotential einer Zusatz-Stromquelle (57) über dem des Behandlungsmediums (12) liegt.

3. Einrichtung nach Anspruch 1 oder 2, gekennzeichnet durch eine impulsartige Zusatz-Strombeaufschlagung, wobei vorzugsweise eine Impulsdauer von Zusatz-Stromstößen im Bereich zwischen 2 msek und 100 msek liegt.

4. Einrichtung nach einem der vorhergehenden Ansprüche, dadurch gekennzeichnet, daß die Zusatz-Stromquelle (57) eine Impulsstromquelle für kurze Zusatz-Stromstöße ist, vorzugsweise mit im Vergleich zu der Stromversorgung (55) höherer Stromstärke, insbesondere um den Faktor 2 bis 10 höherer Stromstärke.

5. Einrichtung nach einem der vorhergehenden Ansprüche, dadurch gekennzeichnet, daß die Kontaktiermittel (50) umlaufende Walzen oder Scheiben umfassen, die an den Gegenständen (14) mit ihrem Außenumfang anliegen, wobei sie insbesondere beidseitig der Oberfläche der Gegenstände einander gegenüberliegend und gegenläufig angeordnet sind.

6. Einrichtung nach einem der vorhergehenden Ansprüche, gekennzeichnet durch eine Zusatz-Kontaktierung über die Kontaktiermittel (50), wobei zusätzlich zu deren Kontaktierung wenigstens eine Zusatz-Kontaktfläche (53) vorgesehen ist, die insbesondere zumindest teilweise die übliche Kontaktierung (52) ersetzt.

7. Einrichtung nach Anspruch 6, dadurch gekennzeichnet, daß die Zusatz-Kontaktfläche (53) und die Kontaktiermittel (50) derart ausgebildet sind, daß in bestimmten Stellungen der Kontaktiermittel bzw. zu bestimmten Zeitpunkten die Zusatz-Kontaktfläche der einzige Berührpunkt von Kontaktiermitteln mit den Gegenständen (14) ist.

8. Einrichtung nach einem der vorhergehenden Ansprüche, dadurch gekennzeichnet, daß die Kontaktiermittel (50) wenigstens zwei elektrisch gegeneinander isolierte, im Behandlungsmedium (12) umlaufende, vorzugsweise elektrisch unterschiedlich kontaktierte, Kontaktsektoren (52) aufweisen, zwischen denen zumindest teilweise Zusatz-Kontaktflächen (53) angeordnet sind.

9. Einrichtung nach einem der Ansprüche 1 bis 5, dadurch gekennzeichnet, daß die Zusatz-Kontaktierung über Zusatz-Kontaktiermittel (59) erfolgt, die zumindest teilweise, insbesondere mit einer Zusatz-Kontaktfläche (53) an den Gegenständen (14) anliegen, wobei vorzugsweise die Zusatz-Kontaktiermittel (59) drehbar sind und die Zusatz-Kontaktfläche (53) an ihrem Außenumfang aufweisen.

10. Einrichtung nach einem der vorhergehenden Ansprüche, dadurch gekennzeichnet, daß die Zusatz-Kontaktflächen (53) begrenzt sind, insbesondere mit einer auf einen bestimmten Bogenwinkel begrenzten Ausdehnung, der insbesondere bei ca. 10° liegt.

11. Einrichtung nach einem der vorhergehenden Ansprüche, gekennzeichnet durch eine mechanische Kommutierung der Zusatz-Kontaktflächen (53) mit den Gegenständen (14) und/oder der Zusatz-Stromquelle (57) zur Erzeugung von kurzen Zusatz-Stromstößen an den Gegenständen (14).

12. Einrichtung nach einem der vorhergehenden Ansprüche, dadurch gekennzeichnet, daß jedes Kontaktiermittel (50) mit einem Teil von Kontaktsektoren (52) oder Zusatz-Kontaktflächen (53) verbundene und außerhalb des Behandlungsmediums (12) angeordnete abschnittsweise Stromeinleitmittel (35 bis 38) aufweist, die entweder an die Stromversorgung (55) oder die Zusatz-Stromquelle (57) angeschlossen sind, wobei insbesondere die Stromeinleitmittel zur mechanischen Kommutierung des Stromflusses an die Kontaktsektoren oder Zusatz-Kontaktflächen, die mit den Gegenständen (14) in Kontakt sind, ausgebildet sind.
